# EUROPEAN PATENT APPLICATION

(11) **EP 1 132 493 A2**
(43) Date of publication of application: **12.09.2001**
(21) Application number: 01105506.8
(22) Date of filing: 05.03.2001
(51) Int. Cl.: C23C 14/12, C23C 16/448, H05B 33/10

(54) **Vapor deposition method of organic compound and refinement method of organic compound**

(30) Priority: 09.03.2000 JP 2000064478
(71) Applicant: Kido, Junji, Kitakatsuragi-gun, Nara-ken 635-0831 (JP); International Manufacturing and Engineering Services Co., Ltd., Fujisawa-shi, Kanagawa-ken (JP)
(72) Inventor: Kido, Junji, Kitakatsuragi-gun, Nara-ken (JP); Endoh, Jun, Int. Manuf. & Engin. Serv. Co., Ltd., Fujisawa-shi, Kanagawa-ken (JP); Mori, Kohichi, Int. Manuf. & Engin. Serv. Co.,Ltd., Fujisawa-shi, Kanagawa-ken (JP); Yokoi, Akira, Int. Manuf. & Engin. Serv. Co.,Ltd., Fujisawa-shi, Kanagawa-ken (JP)
(74) Representative: Schaumburg, Thoenes & Thurn

(57) **Abstract**

A vapor deposition method of an organic compound comprises introducing a mixture of an organic compound powder with a powder or crushed particles of at least one of a ceramic, a metal, and a metal coated with a ceramic in a receptacle ; and heating the receptacle which contains the mixture, in a vacuum, so that the organic compound is sublimated or vaporized, and is deposited onto an object surface so as to form a thin organic compound layer thereon.

## Description

### BACKGROUND OF THE INVENTION

### 1. Field of the invention

The present invention relates to a vapor deposition (thermal evaporation) method of an organic compound and a refinement method of an organic compound.

### 2. Description of the Related Art

In general, a thermal vaporization method in a vacuum is employed as a film forming method for an element having an organic compound thin film which represents an organic electroluminescent element (referred to as organic EL element). Namely, for example, organic compound powder is introduced in a ceramic crucible having a filament wound therearound and the internal organic compound is sublimated to deposit the internal organic compound on an object to be deposited by supplying the filament with electricity to heat the crucible.

However, in the conventional vapor deposition method, since the organic compound whose heat conductivity is low is heated from the outside of the crucible, the heat is not fully distributed in the crucible, so that heat is not uniformly conducted to the organic compound in the crucible. Consequently, in the course of sublimation, part of the organic compound is sublimated but part of the organic compound is not sublimated, thus resulting in attenuation of the sublimation efficiency, leading to a reduced vapor deposition speed. In particular, the portion of the organic compound that is in contact with the inner wall of the crucible is locally overheated and is subject to pyrolysis. If pyrolysis occurs, decomposed components mix in with the formed film, thus leading to deterioration of the efficiency of the element. Moreover, in the case of mass-production, the capacity of the crucible is inevitably increased, and hence the depth of the crucible is increased relative to the diameter of the opening thereof. Consequently, molecules of the organic compound have an orientation due to a chimney effect when the amount of the organic compound reduces as time passes. As a result, it is impossible to uniformly form a film on the surface on which the organic compound is to be deposited. To solve this problem, in conventional apparatuses, a cover having a plurality of holes is provided at the opening of the crucible to prevent molecules of the organic compound from exhibiting an orientation due to the chimney effect.

In a known refinement method of an organic compound, the organic compound introduced in a crucible is heated and the sublimated or vaporized organic compound is cooled to extract only the organic compound. In this method, sufficient refining efficiency is not attained due to the non-uniform heat conductivity to the organic compound, and the portion of the organic compound that is in contact with the inner wall of the crucible is subject to pyrolysis due to overheating, so that the decomposed components are mixed as impurities.

### SUMMARY OF THE INVENTION

It is an object of the present invention to eliminate the drawbacks of the prior art mentioned above, by providing a vapor deposition method of an organic compound in which the organic compound introduced in a receiving container is substantially uniformly heated, thus resulting in high depositing efficiency.

Another object of the present invention is to provide a refinement method of an organic compound in which the organic compound can be refined with high efficiency and high purity.

It has been found that if powder of an organic compound is mixed with a substance having high heat conductivity, such as ceramics, metal, or metal coated with a ceramic, when a receiving container which receives therein the mixture of the organic compound powder with the above described substance is heated, the heat is uniformly conducted to the internal portion of the organic compound powder due to the substance having high (heat) conductivity in the receiving container, so that uniform heating can be achieved and the organic compound is vaporized or sublimated. The invention is embodied as a vapor deposition method and a refinement method.

According to an aspect of the present invention, a vapor deposition method of an organic compound is provided, the method comprises accommodating a mixture of an organic compound powder with one of a powder and crushed particles of at least one of a ceramic, a metal, and a metal coated with a ceramic in a receptacle; and heating the receptacle which accommodates the mixture, in a vacuum, so that the organic compound is sublimated or vaporized, and is deposited onto an object surface so as to form a thin organic compound layer thereon.

Preferably, the mixing ratio of the organic compound powder and at least one of the ceramic, the metal, and the metal coated with a ceramic is in the range of 1:50 to 50:1 in volume.

In an embodiment, the grain diameter of the powder or crushed particles of the ceramic, the metal and the metal coated with a ceramic is in the range of 0.01µm to 6 mm.

The ceramic can be a porous ceramic material.

In an embodiment, the ceramic is a metal oxide, a metal nitride, a carbide or carbon.

In an embodiment, the ceramic is aluminum nitride, silicon carbide or carbon. Any type of carbon can be used. Active carbon, carbon black, graphite etc. can be mentioned as preferable carbon. Among these, graphite having a high theoretical density is most preferable.

The organic compound can be used to form an organic electroluminescent element.

The receptacle can be a crucible or a boat.

According to another aspect of the present invention, a refinement method of an organic compound is provided, the method comprises accommodating a mixture of an organic compound powder with either a powder or crushed particles of at least one of a ceramic, a metal, and a metal coated with a ceramic in a receptacle; and heating the receptacle which accommodates the mixture in a vacuum, so that the organic compound is sublimated or vaporized to extract the organic compound.

Preferably, the mixing ratio of the organic compound powder and at least one of the ceramic, the metal, and the metal coated with a ceramic is in the range of 1:50 to 50:1 in volume.

In an embodiment, the grain diameter of the powder of the ceramic, the metal, and the metal coated with a ceramic is in the range of 0.01µm to 6 mm.

The ceramic can be a porous ceramic material.

In an embodiment, the ceramic is a metal oxide, a metal nitride, a carbide or carbon.

In an embodiment, the ceramic is aluminum nitride, silicon carbide or carbon. Any type of carbon can be used. Active carbon, carbon black, graphite etc. can be mentioned as preferable carbon. Among these, graphite having a high theoretical density is most preferable.

The organic compound can be used to form an organic electroluminescent element.

The receptacle can be a crucible or a boat.

### BRIEF DESCRIPTION OF THE DRAWINGS

The invention will be described below with reference to the accompanying drawings, in which:
Figure 1 is a sectional view of a vapor deposition apparatus to which a vapor deposition method according to the present invention is applied, by way of example;
Figure 2 is a sectional view of a crucible in which powder of an organic compound and ceramic powder are contained;
Figure 3 is a perspective view of a sublimation refinement apparatus (tubular furnace) to which a refinement method of the present invention is applied; and
Figure 4 is a sectional view of a tubular furnace shown in Fig. 3.

### DESCRIPTION OF THE PREFERRED EMBODIMENT

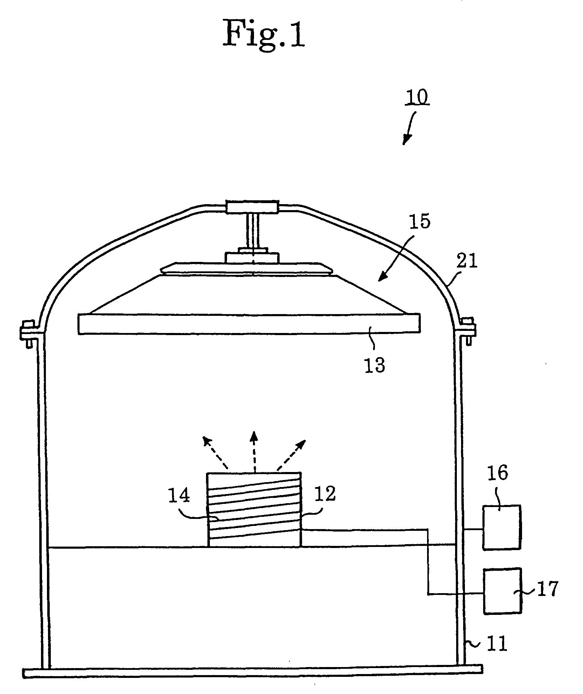

The vapor deposition method of an organic compound, according to the first embodiment, will be discussed below. Figure 1 shows an example of a vapor deposition apparatus 10 which is used to carry out the method of the present invention. The vapor deposition apparatus 10 includes a crucible (receiving container/receptacle) 12 in which a substance to be vaporized is received, a support member 15 which supports an object 13 on which the vaporized substance is to be deposited, a vacuum pump 16, and an electric power source 17 equipped outside of a receiving container. The container body 11 defines, together with a closure 21, a deposition container which is kept in vacuum by the vacuum pump 16 in the course of the vapor deposition. When the substance to be vaporized and the object 13 are introduced or removed from the container body, the closure 21 is detached. The crucible 12 is provided with a filament (electric heating wire) 14 wound therearound, connected to the power source 17. When electricity is supplied to the filament 14 via the power source 17, the filament 14 generates heat so as to heat the crucible 12. The vapor deposition apparatus 10 constructed as above is widely used and is well known. The structure of the vapor deposition apparatus 10 is not the subject of the present invention.

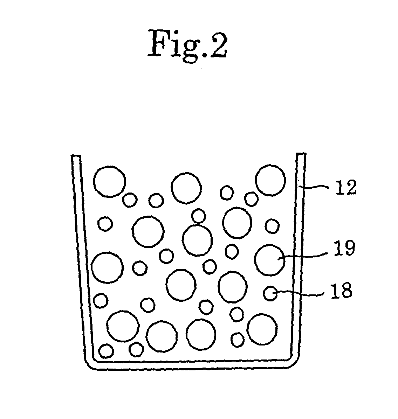

As can be seen in Fig. 2, organic compound powder 18 and ceramic powder 19 are stirred and mixed and contained in the crucible 12. The mixing ratio in volume of the organic compound powder 18 and the ceramic powder 19 is not limited to a specific value but is preferably in the range of 1:50 to 50:1. A sublimating compound, a compound which is vaporized after fusion, or a compound which is vaporized during fusion can be utilized as the organic compound to be vaporized. The ceramic material to be used has a higher heat conductivity than the organic compound, and is not sublimated (vaporized) at a temperature at which the organic compound is sublimated (vaporized). Furthermore, the ceramic material can be a porous ceramic material.

To deposit the organic compound on the object 13, the vacuum pump 16 is driven to create a vacuum within the vapor deposition apparatus 10, and thereafter, the filament 14 is supplied with electricity to heat the crucible 12. When the crucible 12 is heated, the organic compound powder 18 and the ceramic powder 19 in the crucible 12 are heated due to heat transmitted through the inner wall of the crucible 12. Since ceramics have high heat conductivity, the heat of the ceramic powder 19 heated in the vicinity of the inner wall of the crucible 12 is continuously transmitted to the ceramic powder 19 at the center portion of the crucible 12, so that the ceramic powder portion located away from the inner wall of the crucible 12 can be effectively heated. Consequently, the organic compound powder 18 around the ceramic powder portion 19 is heated. When the temperature reaches a predetermined value, the organic compound powder 18 is sublimated (vaporized) and is adhered to and deposited on the object 13 to form a thin organic compound layer thereon. However, no change of the ceramic powder takes place.

As can be understood from the above description, since the mixture of the organic compound powder 18 and the ceramic powder 19 is contained in the crucible 12, the heat of the inner wall of the crucible 12 is transmitted to the center portion of the mixture via the ceramic powder 19, so that all of the organic compound powder 18 in the crucible 12 can be substantially uniformly heated and sublimated (vaporized). Consequently, the vapor deposition can be effectively carried out. Since no overheating of the organic compound powder 18 in the vicinity of the inner wall of the crucible 12 occurs, pyrolysis does not take place, thus resulting in no deterioration of the organic compound. Moreover, if a deep crucible is employed for mass-production, the entirety of the organic compound powder 18 contained in the crucible is uniformly sublimated due to the presence of the ceramic powder 19, and hence no chimney effect occurs if the amount of the organic compound is reduced.

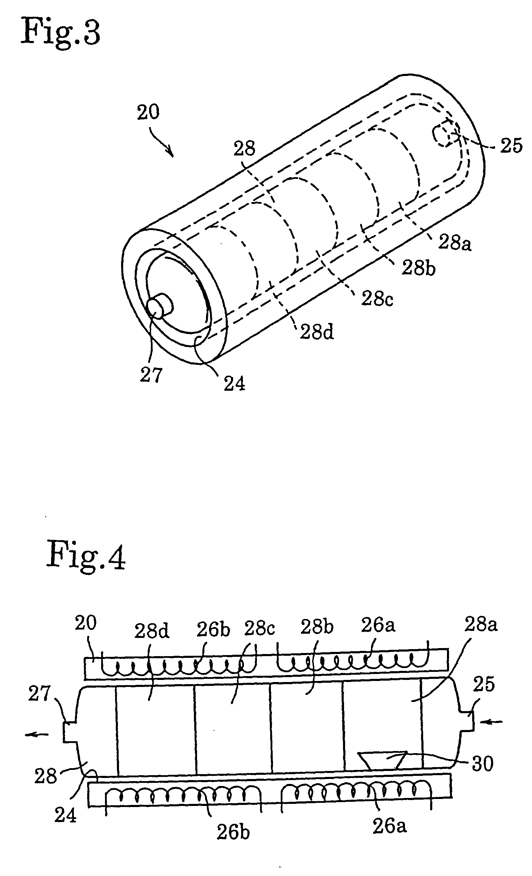

A refinement method of an organic compound according to the second embodiment will be discussed below. Fig. 3 shows a tubular furnace (refinement apparatus) 20 provided as a sublimation and refinement apparatus to carry out a refinement method of the present invention. The tubular furnace 20 includes, as shown in a sectional view of Fig. 4, high temperature and low temperature filaments 26a and 26b which are axially aligned generally in the form of a cylinder around a central bore 24. The temperatures of the high temperature filament 26a and the low temperature filament 26b are determined depending on the organic compound to be refined and can be set to, for example, approximately 300 °C and 150 °C, respectively. A core tube 28 having open ends 25 and 27 is inserted in the central bore 24 of the tubular furnace 20. The core tube 28 is provided with a plurality of transparent quartz tubes 28a through 28d connected in series. The open ends 25 and 27 of the core tube 28 have a reduced diameter. Inert gas such as nitrogen or argon, etc., is introduced in and discharged from the core tube 28 through the open end 25 and the open end 27, respectively. In this state, it is possible to forcibly evacuate the core tube 28 to a negative pressure by a vacuum pump, etc., through the open end 27.

To refine the organic compound, a boat (receiving container/receptacle) 30 which receives therein the organic compound powder to be refined, containing impurities, is disposed in the quartz tube 28a having the high temperature filament 26a wound therearound. Thereafter, the high temperature filament 26a and the low temperature filament 26b are supplied with electricity, and inert gas is introduced in the quartz tube through the right open end with respect to Fig. 4. The boat 30 is heated externally by the high temperature filament 26a, so that pure organic compound molecules to be extracted are sublimated (vaporized) in accordance with an increase in the temperature and are moved together with the inert gas flow. Due to a difference in temperature between the high temperature filament 26a and the low temperature filament 26b, the core tube 28 has a temperature gradient. Consequently, when the sublimated (vaporized) organic compound reaches freezing point, the sublimated organic compound is solidified and sticks to the inner wall of a quartz tube 28a through 28d. The volatile impurities of the organic compound which volatilize even at the set temperature of the low temperature filament 26b is discharged outside together with the inert gas flow. The nonvolatile impurities of the organic compound which do not volatilize even at the set temperature of the high temperature filament 26a remain in the boat 30. The quartz tube (28a through 28d) onto which the refined organic compound has deposited is removed from the tubular furnace, so that the organic compound adhered to the inner wall of the quartz tube (28a through 28d) can be scraped and obtained. The refinement using the tubular furnace 20 as mentioned above is conventional and has been used.

In the refinement method of the present invention, the mixture of the organic compound powder 18 and the ceramic powder 19 (the same mixture as that shown in Fig. 2 of the first embodiment) is received in the boat 30 and is refined in the tubular furnace 20. Since the organic compound powder 18 is mixed with the ceramic powder 19 and is received in the boat 30, the heat of the inner wall of the boat 30 is effectively transmitted to the center portion of the mixture by the ceramic powder 19, so that all of the organic compound powder 18 is substantially uniformly heated and sublimated (vaporized). Thus, the organic compound can be effectively refined. Moreover, since overheating of the organic compound portion located in the vicinity of the inner wall of the boat 30 does not take place, no pyrolysis occurs, and hence a pyrolysate impurity cannot mix in with the mixture.

Although the organic compound powder 18 and the ceramic powder 19 are mixed in the form of a powder and are contained in the crucible 12, in the illustrated embodiment, it is possible to mix both the organic compound powder 18 and ceramic powder 19 together with solvent to obtain a slurry, and dry the slurry to obtain a powder of the mixture.

Although the refinement apparatus employs a tubular furnace, the present invention can be applied to any type of refinement apparatus in which the organic compound is heated and sublimated (vaporized) to refine the organic compound.

In the vapor deposition method of an organic compound and the refinement method of an organic compound, of the present invention, the kind of ceramic to be mixed with the organic compound is not limited. At least, a metal oxide, a metal nitride such as aluminum nitride, a carbide such as silicon carbide, carbon such as active carbon, carbon black, graphite etc. can be used as the ceramic material. Furthermore, a metal, or metal coated with a ceramic can be used in place of the ceramic. By way of example, tantalum or tungsten can be used. A metal coated with a ceramic can be obtained by coating surfaces of metal grains with a ceramic by, for example, ,chemical vapor deposition (CVD) or sputtering, etc. The ceramic, the metal or the metal coated with the ceramic, can be mixed as powders or crushed particles. The grain diameter is preferably in the range of 0.01 µm to 6 mm.

Although the crucible (in the first embodiment) or the boat 30 (in the second embodiment) is used as a receiving container for receiving the organic compound powder, the receiving container is not limited thereto.

It is possible to apply the vapor deposition method of an organic compound of the present invention to a deposition of an organic compound in an organic EL element. The organic compound can be used as a substance for a hole injection layer and hole transporting material, an electron injection layer and electron transporting material, and a light emitting material and a doping material. Consequently, each layer can be effectively formed. Likewise, the refinement method of an organic compound of the present invention can be applied to a refinement of an organic compound in an organic EL element.

According to the present invention, a vapor deposition method of an organic compound having a high deposition efficiency can be provided in which the organic compound received in a receiving container can be heated substantially uniformly. Furthermore, a highly effective organic compound refining method can be provided in which the organic compound can be refined to attain high purity.

Although the invention has been described with reference to particular means, materials and embodiments, it is to be understood that the invention is not limited to the particulars disclosed and extends to all equivalents within the scope of the claims.

## Claims

1. A vapor deposition method of an organic compound, said method comprising:
accommodating a mixture of an organic compound powder with one of a powder and crushed particles of at least one of a ceramic, a metal, and a metal coated with a ceramic in a receptacle; and
heating said receptacle which accommodates said mixture, in a vacuum, so that said organic compound is sublimated and vaporized, and is deposited onto an object surface so as to form a thin organic compound layer thereon.

2. A refinement method of an organic compound, said method comprising:
accommodating a mixture of an organic compound powder with one of a powder and crushed particles of at least one of a ceramic, a metal, and a metal coated with a ceramic in a receptacle; and
heating said receptacle which accommodates said mixture, in a vacuum, so that said organic compound is sublimated and vaporized to extract the organic compound.

3. The method according to claim 1 or 2, wherein a mixing ratio of the organic compound powder and at least one of the ceramic, the metal, and the metal coated with a ceramic is in the range of 1:50 to 50:1 in volume.

4. The method according to any one of claims 1 to 3, wherein the grain diameter of the powder or crushed particles of the ceramic, the metal, and the metal coated with a ceramic is in the range of 0.01µm to 6mm.

5. The method according to any one of claims 1 to 4, wherein the ceramic comprises a porous ceramic material.

6. The method according to any one of claims 1 to 5, wherein the ceramic comprises one of a metal oxide, a metal nitride, a carbide and carbon.

7. The method according to claim 6, wherein the ceramic comprises one of an aluminum nitride, silicon carbide and carbon.

8. The method according to any one of claims 1 to 7, wherein the organic compound is used to form an organic electroluminescent element.

9. The method according to any one of claims 1 to 8, wherein the receptacle is one of a crucible and a boat.
